(19) 

Europäisches Patentamt

European Patent Office

Office européen des brevets

(11) **EP 4 593 291 A1**

(12) **EUROPEAN PATENT APPLICATION**
published in accordance with Art. 153(4) EPC

(43) Date of publication:
**30.07.2025 Bulletin 2025/31**

(21) Application number: **23881283.8**

(22) Date of filing: **28.06.2023**

(51) International Patent Classification (IPC):
***H03L 7/085*** [(2006.01)]

(52) Cooperative Patent Classification (CPC):
**H03L 7/085; H03M 9/00**

(86) International application number:
**PCT/CN2023/103186**

(87) International publication number:
**WO 2024/087694 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **25.10.2022 CN 202211314210**

(71) Applicant: **Huawei Technologies Co., Ltd.
Shenzhen, Guangdong 518129 (CN)**

(72) Inventors:
• **CHEN, Yanqin
Shenzhen, Guangdong 518129 (CN)**
• **WANG, Xiaoting
Shenzhen, Guangdong 518129 (CN)**

(74) Representative: **Maiwald GmbH
Engineering
Elisenhof
Elisenstrasse 3
80335 München (DE)**

(54) **PHASE DETECTOR AND OPERATING METHOD THEREOF, CLOCK AND DATA RECOVERY CIRCUIT, AND ELECTRONIC DEVICE**

(57) Embodiments of this application relate to the field of integrated circuit technologies, and provide a phase detector and an operation method thereof, a clock and data recovery circuit, and an electronic device, to improve performance of a phase detector. The phase detector includes: a data integrator, coupled to a sampling clock end and configured to perform integration on input data based on a signal at a sampling clock end; a data sampling comparator, configured to perform sampling comparison between output of the data integrator and a specified value; a transition edge integrator, coupled to the sampling clock end and configured to perform integration on the input data based on the signal at the sampling clock end; a transition edge sampling comparator, configured to perform sampling comparison between output of the transition edge integrator and the specified value; and a logic processor, configured to perform logic processing on a comparison result of the data sampling comparator and a comparison result of the transition edge sampling comparator, and output a lead or lag processing result.

FIG. 6

**Description**

This application claims priority to Chinese Patent Application No. 202211314210.9, filed with the China National Intellectual Property Administration on October 25, 2022 and entitled "PHASE DETECTOR AND OPERATION METHOD THEREOF, CLOCK AND DATA RECOVERY CIRCUIT, AND ELECTRONIC DEVICE", which is incorporated herein by reference in its entirety.

**TECHNICAL FIELD**

This application relates to the field of integrated circuit technologies, and in particular, to a phase detector and an operation method thereof, a clock and data recovery circuit, and an electronic device.

**BACKGROUND**

In communication transmission of serial data, a transceiver circuit is responsible for conversion between internal parallel data and external serial data. At a transmit end, bit data in parallel data is sent to a transmission medium piece by piece according to a principle of high-speed clock sampling, to implement parallel-to-serial conversion. However, at a receive end, because the transmit end and the receive end do not share a clock signal for data synchronization, the receive end needs to recover a clock signal from a received serial data stream to implement a synchronization operation. A clock and data recovery (clock and data recovery, CDR) circuit is responsible for extracting a recovered clock and recovered data from serial data. Then a next-stage serial-to-parallel circuit converts the recovered data to parallel data for output, and may further determine a feature code pattern of input serial data to implement byte synchronization.

In the CDR circuit, a phase detector needs to be used to determine a phase relationship between a recovered clock signal and a data symbol, so that the clock signal is adjusted by using a feedback loop to obtain an optimal rising edge. Therefore, performance of the phase detector greatly affects accuracy of the CDR circuit.

**SUMMARY**

Embodiments of this application provide a phase detector and an operation method thereof, a clock and data recovery circuit, and an electronic device, to improve performance of a phase detector.

To achieve the foregoing objective, the following technical solutions are used in this application.

According to a first aspect of embodiments of this application, a phase detector is provided, including: a data integrator, coupled to both a data input end and a sampling clock end, and configured to perform integration on input data at the data input end based on a sampling clock at the sampling clock end; a data sampling comparator, coupled to the data integrator and configured to perform sampling comparison between output of the data integrator and a specified value; a transition edge integrator, coupled to both the data input end and the sampling clock end, and configured to perform integration on the input data based on the sampling clock at the sampling clock end; a transition edge sampling comparator, coupled to the transition edge integrator and configured to perform sampling comparison between output of the transition edge integrator and the specified value; and a logic processor, coupled to both the data sampling comparator and the transition edge sampling comparator, and configured to perform logic processing on a comparison result of the data sampling comparator and a comparison result of the transition edge sampling comparator, and output a processing result.

In the phase detector provided in this embodiment of this application, sampling on a data segment in a data stream input to the data input end is equivalently completed by the data integrator, and sampling on a transition edge in the data stream is equivalently completed by the transition edge integrator. To complete the sampling on the data segment and the sampling on the transition edge, an external system only needs to provide one sampling clock for the sampling clock end. A sampling cycle of the sampling clock is equal to one UI, and a sampling rate of the phase detector is equal to a baud rate. This can effectively reduce power consumption of the phase detector and improve performance of the phase detector. On this basis, the data integrator is disposed in a branch of the data sampling comparator, and the transition edge integrator is disposed in a branch of the transition edge sampling comparator. Although a gain of the data integrator and a gain of the transition edge integrator both introduce a delay and non-ideality of an output result, a delay and non-ideality introduced by the data integrator can offset a delay and non-ideality introduced by the transition edge integrator, to alleviate jitter tolerance degradation caused by the introduction of the integrators, improve jitter tolerance of the phase detector, and further improve performance of the phase detector.

In a possible implementation, the phase detector further includes a clock delayer. The sampling clock end, the data integrator, and the transition edge integrator are all coupled to the clock delayer. The clock delayer is configured to receive the sampling clock from the sampling clock end and output a delayed sampling clock. According to the phase detector provided in this embodiment of this application, in some implementation solutions, although the sampling clock and the delayed sampling clock need to be used, the clock delayer is disposed, and the clock delayer outputs the delayed sampling clock. In this way, the external system only needs to provide one sampling clock for the sampling clock end. A gain caused by outputting the delayed sampling clock by the clock delayer can be offset by the gains of the data integrator and the transition edge integrator, to improve performance of the phase detector.

In a possible implementation, the data integrator is configured to perform integration on the input data at the data input end by starting from an $N^{th}$ rising edge of the sampling clock and ending at an $N^{th}$ rising edge of the delayed sampling clock, and the transition edge integrator is configured to perform integration on the input data at the data input end by starting from the $N^{th}$ rising edge of the delayed sampling clock and ending at an $(N+1)^{th}$ rising edge of the sampling clock, where N is a positive integer. This is an implementation with a simple structure.

In a possible implementation, the data integrator is configured to perform integration on the input data at the data input end by starting from an $(N-1)^{th}$ rising edge of the delayed sampling clock and ending at the $N^{th}$ rising edge of the sampling clock, and the transition edge integrator is configured to perform integration on the input data at the data input end by starting from the $N^{th}$ rising edge of the sampling clock and ending at the $N^{th}$ rising edge of the sampling clock, where N is a positive integer. This is an implementation with a simple structure.

In a possible implementation, the data integrator and the transition edge integrator have a same structure. In this way, a circuit structure can be simple, and the gains of the data integrator and the transition edge integrator can also be close to each other.

In a possible implementation, the phase detector further includes a gain controller. The gain controller is coupled to the transition edge integrator and is configured to output a bias current to the transition edge integrator. With the gain controller disposed in the phase detector, the gain controller may compensate for the gain of the transition edge integrator, so that the gain of the data integrator is equal to the gain of the transition edge integrator to a maximum extent. In this way, the delay and the non-ideality introduced by the data integrator can offset the delay and the non-ideality introduced by the transition edge integrator to a maximum extent, to improve performance of the phase detector.

In a possible implementation, the gain controller includes an operational amplifier, an inverter, a first transistor, a second transistor, a first switch, a second switch, and a capacitor. An input end of the operational amplifier is coupled to a reference voltage end, another input end of the operational amplifier is coupled to a first node, and an output end of the operational amplifier is coupled to a gate of the first transistor. A first electrode of the first transistor is coupled to a first voltage end, and a second electrode of the first transistor is coupled to the first node. A gate of the second transistor is coupled to the output end of the operational amplifier, a first electrode of the second transistor is coupled to the first voltage end, and a second electrode of the second transistor is coupled to the transition edge integrator. The first switch is coupled between the first node and a second node, and a control end of the first switch is coupled to the sampling clock end. An input end of the inverter is coupled to the sampling clock end, and an output end of the inverter is coupled to a control end of the second switch. The second switch and the capacitor are coupled in parallel between the second node and a second voltage end. This is an implementation with a simple structure.

In a possible implementation, the clock delayer includes a buffer. This is an implementation with a simple structure.

In a possible implementation, the logic processor has a first output end and a second output end. The logic processor is configured to output a digital signal from the first output end, to represent that a phase of the sampling clock leads a phase of the input data; or the logic processor is configured to output the digital signal from the second output end, to represent that a phase of the sampling clock lags behind a phase of the input data. This is an implementation with a simple structure.

In a possible implementation, the specified value is 0. This is an implementation with a simple structure.

According to a second aspect of embodiments of this application, a clock and data recovery circuit is provided, including a phase detector and a charge pump. The phase detector is the phase detector according to any one of the implementations of the first aspect, and the phase detector is coupled to the charge pump.

The clock and data recovery circuit provided in the second aspect of embodiments of this application includes the phase detector according to any one of the implementations of the first aspect. Benefits of the clock and data recovery circuit are the same as the benefits of the phase detector. Details are not described herein again.

According to a third aspect of embodiments of this application, an electronic device is provided, including a drive chip and a clock and data recovery circuit. The clock and data recovery circuit is disposed in the drive chip, and the clock and data recovery circuit is the clock and data recovery circuit according to the second aspect.

According to a fourth aspect of embodiments of this application, an operation method for a phase detector is provided, including: A data integrator performs integration on input data at a data input end. A data sampling comparator performs sampling comparison between output of the data integrator and a specified value. A transition edge integrator performs integration on the input data. A transition edge sampling comparator performs sampling comparison between output of the transition edge integrator and the specified value. A logic processor performs logic processing on a comparison result of the data sampling comparator and a comparison result of the transition edge sampling comparator, and outputs a processing result.

Benefits of the operation method for the phase detector according to the fourth aspect of embodiments of this application are the same as the benefits of the phase detector. Details are not described herein again.

**BRIEF DESCRIPTION OF DRAWINGS**

FIG. 1A is a diagram of a framework of an electronic device according to an embodiment of this application;

FIG. 1B is a diagram of a layout of an electronic device according to an embodiment of this application;

FIG. 1C is a diagram of a framework of a source drive circuit according to an embodiment of this application;

FIG. 1D is a diagram of a framework of a clock and data recovery circuit according to an embodiment of this application;

FIG. 2A is a diagram of a framework of a phase detector according to an embodiment of this application;

FIG. 2B and FIG. 2C are diagrams of a principle of a phase detector shown in FIG. 2A according to an embodiment of this application;

FIG. 3A is a diagram of a framework of a phase detector according to an embodiment of this application;

FIG. 3B is a diagram of a principle of an integrator according to an embodiment of this application;

FIG. 3C is a diagram of a principle of a phase detector shown in FIG. 2A according to an embodiment of this application;

FIG. 3D is a diagram of a principle of another phase detector according to an embodiment of this application;

FIG. 4A is a diagram of a structure of a phase detector according to an embodiment of this application;

FIG. 4B is a diagram of a structure of another phase detector according to an embodiment of this application;

FIG. 5A is a diagram of a principle of a phase detector according to an embodiment of this application;

FIG. 5B is a diagram of jitter tolerance of a phase detector according to an embodiment of this application;

FIG. 5C is a diagram of a principle of another phase detector according to an embodiment of this application;

FIG. 6 is a diagram of a structure of still another phase detector according to an embodiment of this application; and

FIG. 7 is a diagram of a structure of a gain controller according to an embodiment of this application.

**DESCRIPTION OF EMBODIMENTS**

The following describes technical solutions in embodiments of this application with reference to accompanying drawings in embodiments of this application. Clearly, the described embodiments are merely some but not all of embodiments of this application.

The terms "second", "first", and the like below are merely intended for ease of description, and shall not be understood as controlling or implying relative importance or implicitly indicating a quantity of controlled technical features. Therefore, a feature limited by "second", "first", or the like may explicitly or implicitly include one or more features. In descriptions of this application, "a plurality of" means two or more, unless otherwise specified.

In addition, in embodiments of this application, orientation terms such as "upper", "lower", "left", and "right" may include but are not limited to being defined relative to placement orientations of components shown in the accompanying drawings. It should be understood that these directional terms may be relative concepts and are used for relative description and clarification, and may vary correspondingly based on changes in the placement orientations of the components in the accompanying drawings.

In embodiments of this application, unless otherwise clearly specified and limited, the term "connection" should be understood in a broad sense. For example, the "connection" may be a fixed connection, a detachable connection, or an integrated connection, or may be a direct connection or an indirect connection implemented through an intermediate medium. In addition, the term "coupling" may be a direct electrical connection, or may be an indirect electrical connection through an intermediate medium. The term "contact" may be direct contact or indirect contact through an intermediate medium.

In embodiments of this application, "and/or" describes an association relationship between associated objects, and indicates that three relationships may exist. For example, A and/or B may indicate the following cases: Only A exists, both A and B exist, and only B exists, where A and B may be in a singular form or a plural form. The character "/" usually indicates an "or" relationship between the associated objects.

Before details of embodiments of this application are described, definitions of technical terms used in embodiments of this application are first described.

Clock and data recovery (clock and data recovery, CDR) circuit: A corresponding frequency clock is recovered based on input data, and then data is sampled by using the clock.

Phase detector (PHASE DETECTOR, PD for short): a circuit, in a clock and data recovery circuit, that is configured to detect a phase difference between a sampling clock and input data.

Baud rate: For data within the discussion scope of embodiments of this application, the baud rate is a data transmission rate. For example, a baud rate corresponding to 3 Gb/S is 3 Gb/S.

Baud rate sampling phase detector: a phase detector whose sampling rate is equal to a baud rate of input data.

BANG BANG phase detector (BANG BANG phase detector, BBPD): a name of the most conventional phase detector circuit whose sampling rate is twice a baud rate.

Sampling comparator: Generally, the sampling comparator compares an input signal with 0 when a rising edge of an input clock arrives, and outputs a high level if the input signal is greater than 0, or outputs a low level if the input signal is less than 0.

UI (unit interval): indicates a minimum unit interval for data transmission. For example, a UI for a data rate of 3 Gb/S is 333.3333 pS.

Non-ideality: includes clock injection, clock feed-through, charge sharing, nonlinearity, setup time, and the like of an integrator. All these factors actually can be equivalent to a delay of the integrator.

Jitter tolerance (jitter tolerance): a core indicator for measuring performance of a clock and data recovery circuit. Generally, the jitter tolerance indicates data jitter that the circuit can tolerate. Generally, if jitter is so large that a sampling clock falls on a transition edge of data, it is considered that an error occurs in circuit sampling.

Buffer (buffer) and inverter (inverter): Both are the most basic digital logic processors. Output and input of the buffer are in a same direction. Input and output of the inverter are in opposite directions.

Negative feedback: A system reduces an error at a sampling end through feedback. In an implementation, in a clock and data recovery circuit, a phase of a sampling clock is made to be close to an ideal position through feedback.

An embodiment of this application provides an electronic device. The electronic device is, for example, a consumer electronic product, a home electronic product, a vehicle-mounted electronic product, a financial terminal product, or an electronic device for video transmission. The consumer electronic product is, for example, a mobile phone (mobile phone), a tablet computer (pad), a notebook computer, an e-reader, a personal computer (personal computer, PC), a personal digital assistant (personal digital assistant, PDA), a desktop display, an intelligent wearable product (for example, a smartwatch or a smart band), a virtual reality (virtual reality, VR) terminal device, an augmented reality (augmented reality, AR) terminal device, or an uncrewed aerial vehicle. The home electronic product is, for example, a smart door lock, a television, a remote control, a refrigerator, or a small charging home appliance (for example, a soy milk maker or a robot vacuum). The vehicle-mounted electronic product is, for example, a vehicle-mounted navigator or a vehicle-mounted high-density digital video disc (digital video disc, DVD). The financial terminal product is, for example, an automated teller machine (automated teller machine, ATM) or a terminal for self-help service handling. The electronic device for video transmission is, for example, a backend product such as a network video recorder (network video recorder, NVR), a digital video recorder (digital video recorder, DVR), a digital hard disk recorder (XVR), an encoder (DVS), an all-in-one machine, an industrial computer, a gateway, or an industry host. The electronic device may alternatively be an electronic device with an audio/video transmission requirement, for example, a set-top box.

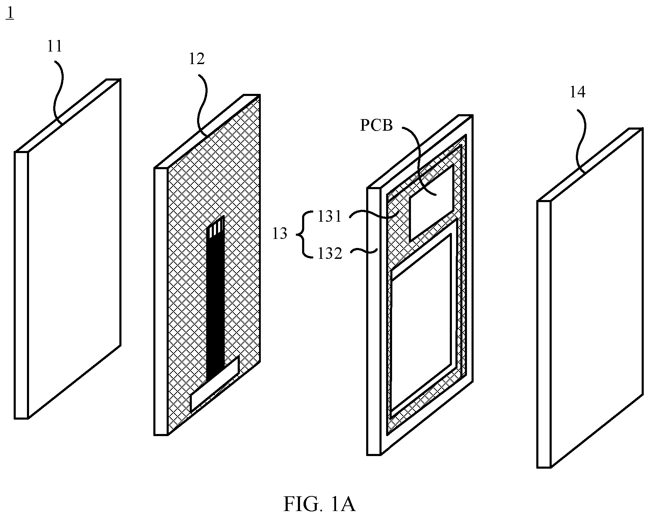

For ease of description, an example in which the electronic device is a tablet computer is used below for description. As shown in FIG. 1A, an electronic device 1 mainly includes a cover 11, a display panel 12, a middle frame 13, and a rear housing 14. The rear housing 14 and the display panel 12 are respectively located on two sides of the middle frame 13, and the middle frame 13 and the display panel 12 are disposed in the rear housing 14. The cover 11 is disposed on a side, away from the middle frame 13, of the display panel 12. A display surface of the display panel 12 faces the cover 11.

The display panel 12 may be a liquid crystal display (liquid crystal display, LCD). In this case, the liquid crystal display includes a liquid crystal display panel and a backlight module. The liquid crystal display panel is disposed between the cover 11 and the backlight module. The backlight module is configured to provide a light source for the liquid crystal display panel. The display panel 12 may alternatively be an organic light-emitting diode (organic light-emitting diode, OLED) display. Because the OLED display is a self-luminous display, no backlight module needs to be disposed.

The middle frame 13 includes a bearing plate 131 and a side frame 132 surrounding the bearing plate 131. The electronic device 1 may further include electronic components such as a printed circuit board (printed circuit board, PCB), a battery, and a camera. The electronic components such as the printed circuit board, the battery, and the camera may be disposed on the bearing plate 131.

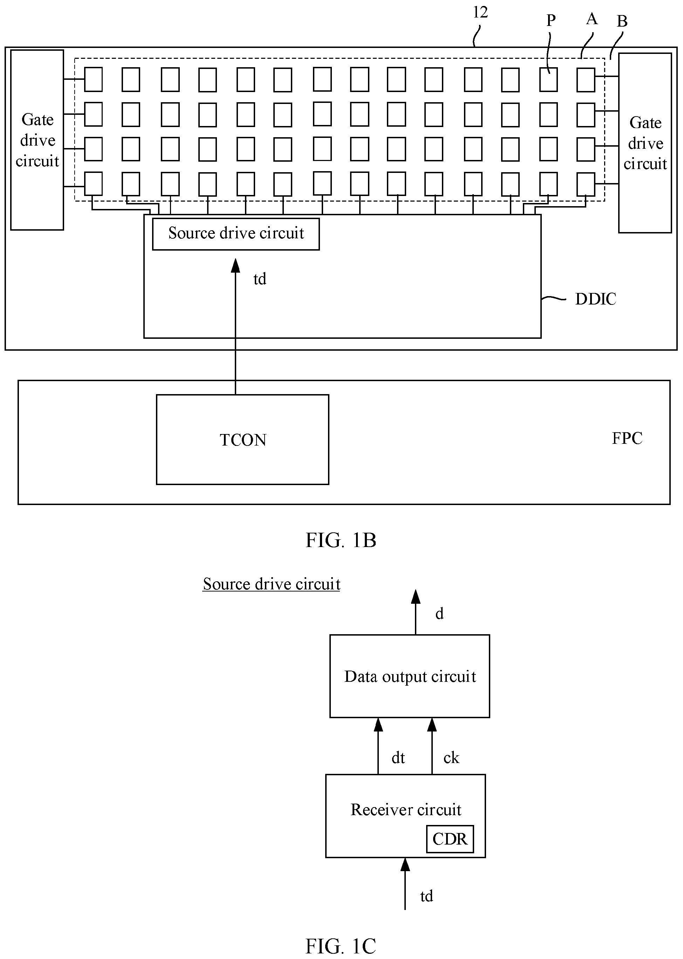

As shown in FIG. 1B, the display panel 12 includes an active area (active area, AA) A and a peripheral area B located around the active area A.

In some embodiments, the active area A of the display panel 12 is used as a display area of the electronic device 1, and the peripheral area B of the display panel 12 is used as a non-display area of the electronic device 1.

As shown in FIG. 1B, the active area A of the display panel 12 includes a plurality of subpixels (subpixel) P. For ease of description, in this application, an example in which the plurality of subpixels P are arranged in a form of a matrix is used for description. In this case, subpixels P arranged in a line along a horizontal direction are referred to as subpixels in a same row, and subpixels P arranged in a line along a vertical direction are referred to as subpixels in a same column.

The electronic device 1 includes a gate drive circuit and a source drive circuit that are located in the peripheral area B of the display panel 12. The gate drive circuit is configured to provide a gate drive signal for the subpixels P. The source drive circuit is configured to provide a source drive signal for the subpixels P.

For example, the gate drive circuit may be integrated into the display panel 12 by using a gate on array (gate on array, GOA) technology. The gate drive circuit includes a plurality of cascaded shift registers (shift register, SR).

There may be one or more gate drive circuits. For example, as shown in FIG. 1B, the electronic device 1 includes two gate drive circuits, and the two gate drive circuits are disposed on two sides of the active area A along the horizontal direction.

For example, the source drive circuit may be integrated into a drive chip (display driver integrated circuit, DDIC). For example, the drive chip DDIC is directly attached to the display panel 12 in a form of a die (die).

The electronic device further includes a timing controller (timing controller, TCON). In some embodiments, as shown in FIG. 1B, the timing controller is disposed on a flexible printed circuit (flexible printed circuit, FPC) board.

In some embodiments, as shown in FIG. 1C, the source drive circuit includes a receiver circuit and a data output circuit. The receiver circuit may receive input data td provided by the timing controller TCON shown in FIG. 1B, and may recover a data signal dt and a clock signal ck.

The data output circuit may synchronously convert the data signal dt and the clock signal ck to a data drive signal d, and apply the data drive signal d to the subpixels P shown in FIG. 1B.

The receiver circuit includes a clock and data recovery CDR circuit, and the clock and data recovery CDR circuit may recover the clock signal ck and the data signal dt based on a transmit signal td.

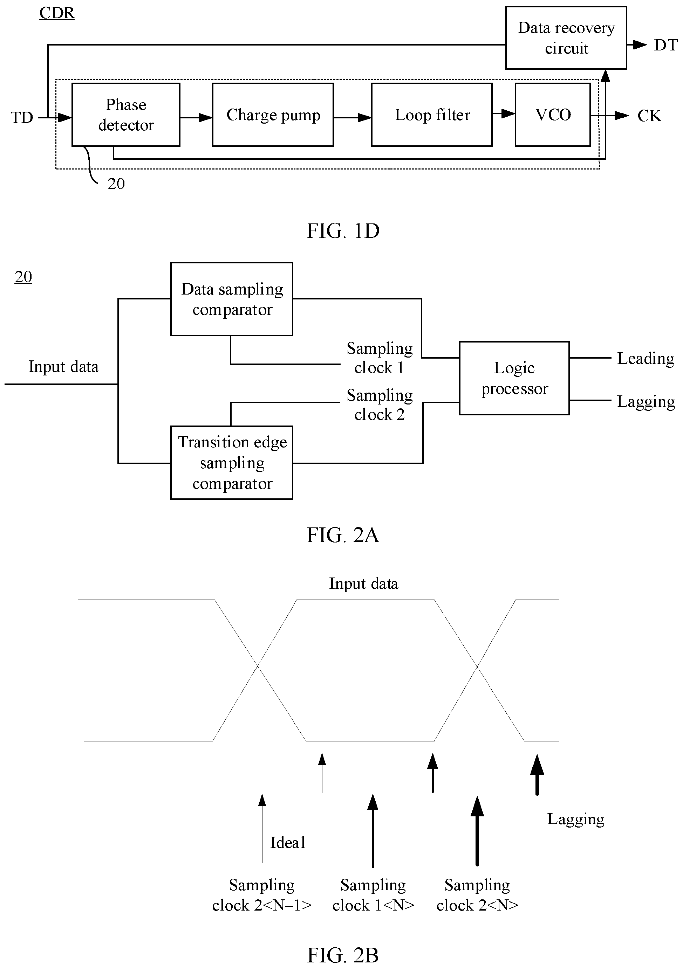

In some embodiments, as shown in FIG. 1D, the clock and data recovery CDR circuit includes a data recovery circuit and a clock recovery circuit. The clock recovery circuit may receive the input data td, and may output the clock signal ck. The data recovery circuit may receive the input data td, and synchronously recover the data signal dt and the clock signal ck to the data signal dt.

For example, the clock recovery circuit includes a phase detector 20, a charge pump, a loop filter, and a voltage-controlled oscillator VCO.

The phase detector 20 may detect a phase difference between the data signal dt and the clock signal ck, and output a phase difference signal PD. The charge pump may output a bias current control signal in response to the phase difference signal PD that comes from the phase detector 20. The loop filter may output a voltage control signal corresponding to the current control signal. The voltage-controlled oscillator VCO may output a clock signal ck that has a frequency corresponding to a voltage level of the voltage control signal.

With development of analog technologies, high-rate circuits are increasingly popularized, and power consumption of chips is also increasing. A low-power clock and data recovery CDR circuit has become a mainstream circuit. A phase detector commonly used in the low-power clock and data recovery CDR circuit includes a BANG BANG phase detector and a baud rate sampling phase detector.

In some technologies, as shown in FIG. 2A, the BANG BANG phase detector includes a data sampling comparator, a transition edge sampling comparator, and a logic controller. Both the data sampling comparator and the transition edge sampling comparator are coupled to the logic controller. A system generates a sampling clock 1 and a sampling clock 2. The sampling clock 1 and the sampling clock 2 are used for data sampling and transition edge sampling respectively. The logic controller performs an exclusive OR operation based on sampling results of the sampling clock 1 and the sampling clock 2, to obtain a phase relationship (including two phase relationships: leading and lagging) between a current sampling clock and input data.

A specific implementation principle is as follows:

As shown in FIG. 2B, the sampling clock 1 and the sampling clock 2 are half a UI apart. The sampling clock 1 is used to drive data sampling, and the sampling clock 2 is used to drive transition edge sampling. For example, rising edges of the sampling clock 1 and the sampling clock 2 may be used for sampling. A sampling clock 1<N> indicated by a dashed line represents an <N>th rising edge of the sampling clock 1. A sampling clock 2<N-1> indicated by a solid line represents an <N-1>th rising edge of the sampling clock 2. A sampling clock 2<N> indicated by a dotted line represents an <N>th rising edge of the sampling clock 2. An ideal sampling position for the sampling clock 1 should be located in the middle of a UI. A reason lies in that, in this case, direct distances between the sampling clock 1 and data transition edges on two sides are the longest, and therefore no error is likely to occur.

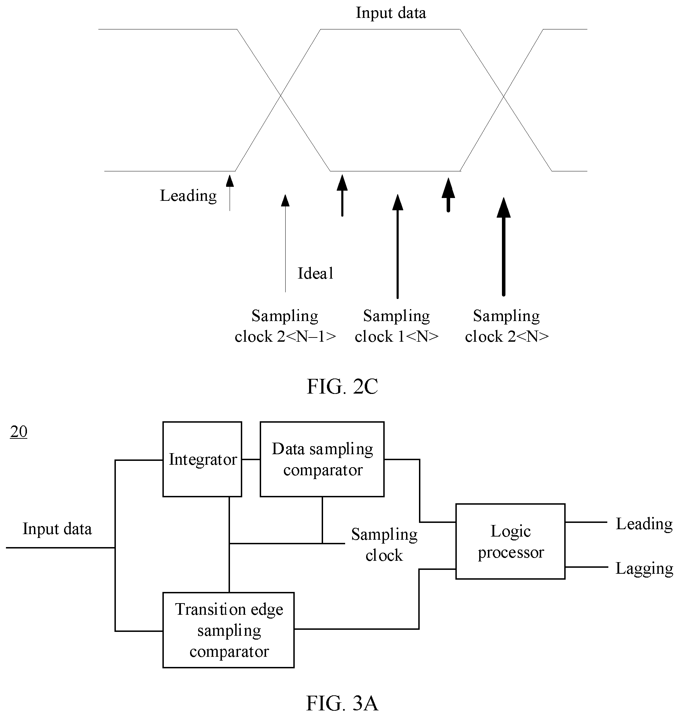

As shown in FIG. 2B, when the sampling clock 1 lags behind the ideal sampling position, sampling results of the sampling clock 1<N> and the sampling clock 2<N> are different, and the logic processor correspondingly determines that lagging occurs. As shown in FIG. 2C, when the sampling clock 1 leads the ideal sampling position, sampling results of the sampling clock 1<N> and the sampling clock 2<N-1> are different, and the logic processor correspondingly determines that leading occurs. When the sampling clock 1 falls at the ideal position, the sampling clock 2 falls at a data transition edge position. In this case, a sampling result is random. To be specific, the logic processor randomly determines whether leading or lagging occurs, and consequently, the system oscillates between leading and lagging.

In the foregoing phase detector, because the sampling clock 1 and the sampling clock 2 are only 0.5 UIs apart, a sampling rate of the phase detector is twice a baud rate, leading to high power consumption of the phase detector.

In view of this, an embodiment of this application provides a phase detector 20. As shown in FIG. 3A, the phase detector 20 includes an integrator, a data sampling comparator, a transition edge sampling comparator, and a logic controller. The integrator is coupled to the data sampling comparator. Both the data sampling comparator and the transition edge sampling comparator are coupled to the logic controller. A system generates a sampling clock, and the sampling clock is used for data sampling and transition edge sampling.

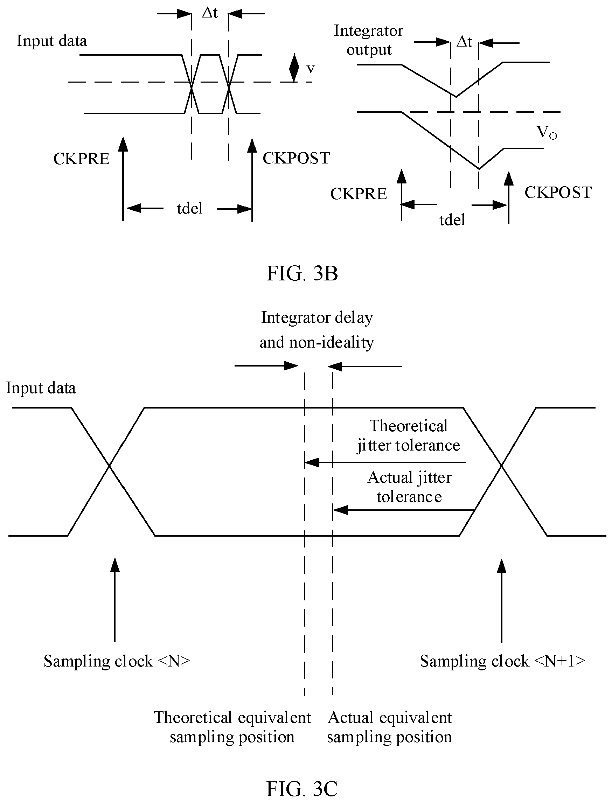

However, as shown in FIG. 3B, the sampling clock has a first rising edge CKPRE and a second rising edge CKPOST, where the first rising edge CKPRE is a current rising edge of the sampling clock, and the second rising edge CKPOST is a rising edge of the sampling clock in a next cycle. There is delay time tdel between the first rising edge CKPRE and the second rising edge CKPOST.

The integrator starts to perform integration on input data at a moment of the first rising edge CKPRE, and stops integration at a moment of the second rising edge CKPOST. When a transition edge of the input data exactly falls in the middle between the first rising edge CKPRE and the second rising edge CKPOST, an output voltage $V_O$ of the integrator is 0. In this case, an average value of an input voltage is also 0. When the transition edge of the input data is staggered from the middle between the first rising edge CKPRE and the second rising edge CKPOST by $\Delta t$, the output voltage $V_O$ of the integrator is as follows:

$$V_O = -2 * \frac{I}{C_O} * \Delta t,$$

where
I is a bias current of the integrator, and $C_O$ is an output capacitance of the integrator.

In this case, the average value $V_I$ of the input voltage is as follows:

$$V_I = -\frac{V}{tdel} * \left( \frac{tdel}{2} + \Delta t \right) + \frac{V}{tdel} \left( \frac{tdel}{2} - \Delta t \right) = -2 * V * \frac{\Delta t}{tdel},$$

where
V is a differential amplitude of the input data.

It can be learned that output of the integrator is directly proportional to an average input voltage, and a gain G of the integrator is as follows:

$$G = \frac{I}{C_O} * \frac{tdel}{V}$$

An implementation principle of the phase detector is as follows:

As shown in FIG. 3C, the sampling clock directly drives a data transition edge sampler, and an ideal position for the sampling clock is in the middle of a data transition edge. An <N>th rising edge and an <N+1>th rising edge of the sampling clock jointly drive the integrator. When the <N>th rising edge of the sampling clock arrives, the integrator starts integration. When the <N+1>th rising edge of the sampling clock arrives, the integrator stops integration. In this case, output of the integrator is directly proportional to an average value of input data between the <N>th rising edge of the sampling clock and the <N+1>th rising edge of the sampling clock. It can also be considered that an equivalent sampling position for integration is at a position indicated by dashed lines in FIG. 3C. The logic controller performs an exclusive OR operation based on the <N>th rising edge and the <N+1>th rising edge of the sampling clock and a sampling result of an equivalent sampling clock, to obtain a phase relationship (including two phase relationships: leading and lagging) between the current sampling clock and the input data.

In this technical solution, there is only one sampling clock, and a sampling cycle of the sampling clock is equal to one UI. Therefore, in this case, a sampling rate of the phase detector is equal to a baud rate, so that power consumption can be reduced.

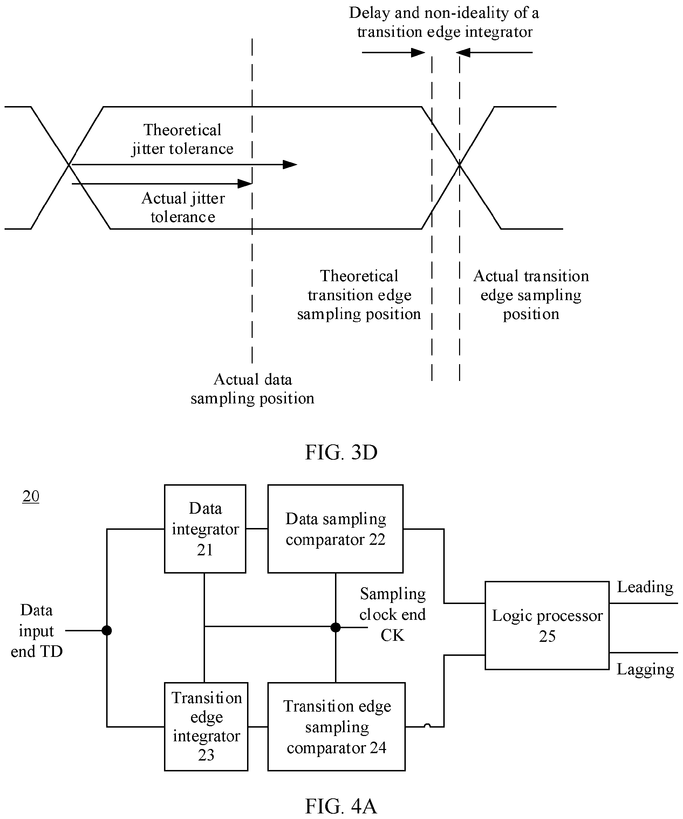

However, the integrator is arranged before the data sampler, and no integrator is arranged before the transition edge sampling comparator. The integrator has a gain G. Therefore, the integrator introduces a specific delay and non-ideality. Therefore, as shown in FIG. 3C, an actual equivalent sampling position obtained through actual integration lags behind a theoretical equivalent sampling position. In this case, the actual equivalent sampling position is closer to a next data transition edge, leading to degradation of jitter tolerance. It should be noted that, even if the integrator is moved to a transition edge sampling position, as shown in FIG. 3D, jitter tolerance is still affected. A reason lies in that, according to a principle of negative feedback, a final equivalent sampling clock is aligned with a data transition edge, and therefore a final data sampling position is still offset from the middle of a UI.

In view of this, an embodiment of this application further provides a phase detector. As shown in FIG. 4A, the phase detector 20 includes a data integrator 21, a data sampling comparator 22, a transition edge integrator 23, a transition edge sampling comparator 24, and a logic processor 25.

The data integrator 21 is coupled to both a data input end TD and a sampling clock end CK, and is configured to perform integration on input data at the data input end TD.

In this embodiment of this application, a data stream input to the data input end TD may be a data signal, or a data stream input to the data input end TD may be a clock signal.

Under the control of a sampling clock at the sampling clock end CK, the data integrator 21 performs integration on the data stream input to the data input end TD. Within an effective integration period of the data integrator 21, data on which the data integrator 21 performs integration does not include a transition edge of the data stream. Output of the data integrator 21 is equivalent to data at a middle position in a data segment that is input to the data integrator 21 within the effective integration period of the data integrator 21.

This is equivalent to that the data integrator 21 completes sampling on the data segment in the data stream input to the data input end TD.

The data sampling comparator 22 is coupled to both the data integrator 21 and the sampling clock end CK, and is configured to perform sampling comparison between the output of the data integrator 21 and a specified value based on the sampling clock at the sampling clock end CK.

For example, the specified value is a median of differential data output by the data input end TD. For example, the specified value is 0.

The transition edge integrator 23 is coupled to both the data input end TD and the sampling clock end CK, and is configured to perform integration on the input data at the data input end TD.

Under the control of the sampling clock at the sampling clock end CK, the transition edge integrator 23 performs integration on the data stream input to the data input end TD. Within an effective integration period of the transition edge integrator 23, data on which the transition edge integrator 23 performs integration includes a transition edge of the data stream. Output of the transition edge integrator 23 is equivalent to data at a middle position in a data segment that is input to the transition edge integrator 23 within the effective integration period of the transition edge integrator 23.

This is equivalent to that the transition edge integrator 23 completes sampling on the transition edge in the data stream input to the data input end TD.

In some embodiments, a structure of the data integrator 21 is the same as a structure of the transition edge integrator 23, and the data integrator 21 and the transition edge integrator 23 are configured to perform integration on data, in different time periods, of the data stream.

The transition edge sampling comparator 24 is coupled to both the transition edge integrator 23 and the sampling clock end CK, and is configured to perform sampling comparison between the output of the transition edge integrator 23 and the specified value based on the sampling clock at the sampling clock end CK.

An output end of the data sampling comparator 22 and an output end of the transition edge sampling comparator 24 are coupled to the logic processor 25. The logic processor 25 is configured to perform logic processing on a comparison result of the data sampling comparator 22 and a comparison result of the transition edge sampling comparator 24, and output a processing result.

For example, the logic processor 25 outputs a first signal and a second signal. The first signal represents that a phase of the sampling clock at the sampling clock end CK leads a phase of the input data at the data input end TD. The second signal represents that a phase of the sampling clock lags behind a phase of the input data at the data input end TD.

In the phase detector 20 provided in this embodiment of this application, sampling on the data segment in the data stream input to the data input end TD is equivalently completed by the data integrator 21, and sampling on the transition edge in the data stream is equivalently completed by the transition edge integrator 23. To complete the sampling on the data segment and the sampling on the transition edge, an external system only needs to provide one sampling clock for the sampling clock end CK. A sampling cycle of the sampling clock is equal to one UI, and a sampling rate of the phase detector is equal to a baud rate. This can effectively reduce power consumption of the phase detector 20 and improve performance of the phase detector 20. On this basis, the data integrator 21 is disposed in a branch of the data sampling comparator 22, and the transition edge integrator 23 is disposed in a branch of the transition edge sampling comparator 24. Although a gain of the data integrator 21 and a gain of the transition edge integrator 23 both introduce a delay and non-ideality of an output result, a delay and non-ideality introduced by the data integrator 21 can offset a delay and non-ideality introduced by the transition edge integrator 23, to alleviate jitter tolerance degradation caused by the introduction of the integrators, improve jitter tolerance of the phase detector 20, and further improve performance of the phase detector 20.

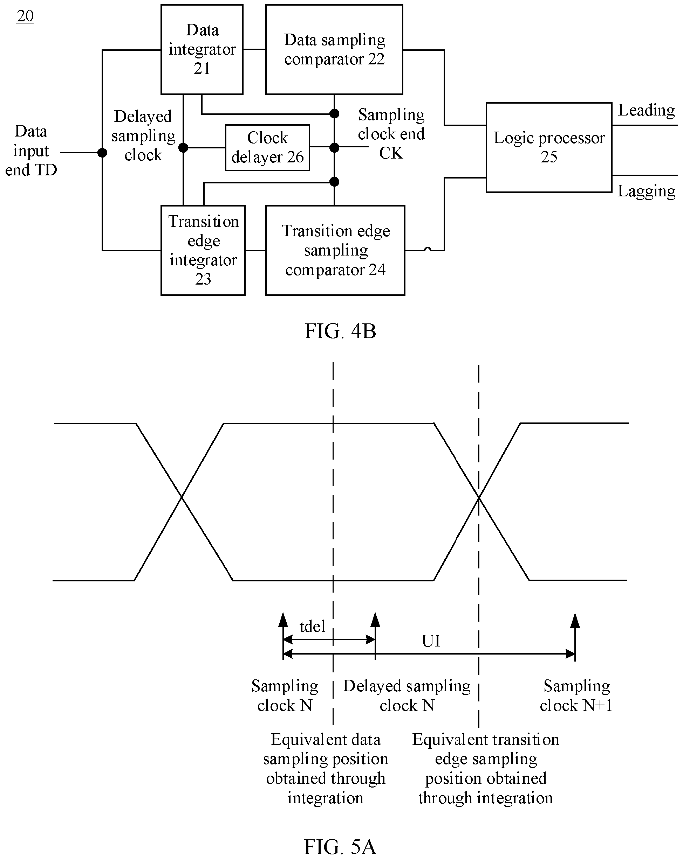

In some embodiments, as shown in FIG. 4B, the phase detector 20 further includes a clock delayer 26.

The sampling clock end CK, the data integrator 21, and the transition edge integrator 23 are all coupled to the clock delayer 26. The clock delayer 26 is configured to receive the sampling clock from the sampling clock end CK and output a delayed sampling clock.

Under the control of the sampling clock at the sampling clock end CK and the delayed sampling clock output by the clock delayer 26, the data integrator 21 performs integration on the data stream input to the data input end TD. Under the control of the sampling clock at the sampling clock end CK and the delayed sampling clock output by the clock delayer 26, the transition edge integrator 23 performs integration on the data stream input to the data input end TD. Both the data integrator 21 and the transition edge integrator 23 are controlled by the sampling clock and the delayed sampling clock.

For example, the clock delayer 26 includes a buffer (buffer).

According to the phase detector 20 provided in this embodiment of this application, in some implementation solutions, although the sampling clock and the delayed sampling clock need to be used, the clock delayer 26 is disposed, and the clock delayer 26 outputs the delayed sampling clock. In this way, the external system only needs to provide one sampling clock for the sampling clock end CK. A gain caused by outputting the delayed sampling clock by the clock delayer 26 can be offset by the gains of the data integrator 21 and the transition edge integrator 23, to improve performance of the phase detector 20.

In some embodiments, the phase detector 20 is controlled by the sampling clock and the delayed sampling clock.

As shown in FIG. 5A, the data integrator 21 is configured to perform integration on the input data at the data input end TD by starting from an $N^{th}$ rising edge of the sampling clock and ending at an $N^{th}$ rising edge of the delayed sampling clock. N is a positive integer.

In this case, after the data sampling comparator 22 receives a sampling indication from the sampling clock, an equivalent data sampling position for the input data falls between the $N^{th}$ rising edge of the sampling clock and the $N^{th}$ rising edge of the delayed sampling clock.

The transition edge integrator 23 is configured to perform integration on the input data at the data input end TD by starting from the $N^{th}$ rising edge of the delayed sampling clock and ending at an $(N+1)^{th}$ rising edge of the sampling clock.

In this case, after the transition sampling integrator 23 receives a sampling indication from the sampling clock, an equivalent transition edge sampling position for the input data falls between the $N^{th}$ rising edge of the delayed sampling clock and the $(N+1)^{th}$ rising edge of the sampling clock.

Specific calculation is as follows:

In this case, the following can be obtained:

sampling moment of the delayed sampling clock $t_{del} < N >= t < N > +tdel;$

$$\text{equivalent data sampling moment} = \frac{1}{2} * (t < N > +t_{del} < N >) = t < N > +\frac{tdel}{2} \text{; and}$$

$$\text{equivalent transition edge sampling moment} = \frac{1}{2} * (t_{del} < N > +t < N+1 >) = t < N > +\frac{tdel}{2} +\frac{UI}{2} \text{, where}$$

$t < N >$ is an $N^{th}$ rising edge moment of the sampling clock, $t < N + 1 >$ is an $(N+1)^{th}$ rising edge moment of the sampling clock, $t_{del} < N >$ is an $N^{th}$ rising edge moment of the delayed sampling clock, and $tdel$ is delay time between delayed sampling clocks.

It can be learned from the formulas that a difference between the equivalent data sampling moment and the equivalent transition edge sampling moment is UI/2. Therefore, it can be considered that a function of a BANG BANG phase detector can be implemented. In addition, the system needs to provide only one sampling clock. Therefore, baud rate sampling characteristics are also implemented.

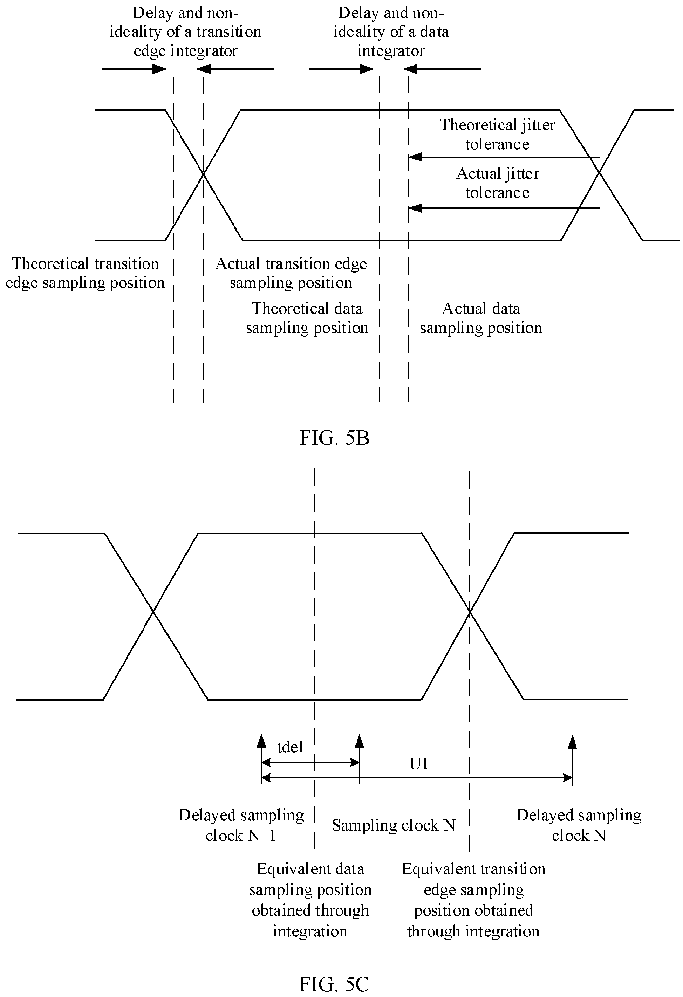

As shown in FIG. 5B, the data integrator 21 is disposed in a branch of the data sampling comparator 22, and the transition edge integrator 23 is disposed in a branch of the transition edge sampling comparator 24. Therefore, due to impact of a delay and non-ideality, an actual equivalent data sampling position is offset by one delay relative to a theoretical equivalent data sampling position, and an actual equivalent transition edge sampling position is offset by one delay relative to a theoretical equivalent transition edge sampling position. According to a principle of negative feedback, an offset transition edge sampling position is aligned with a data transition edge. Because the difference between the equivalent data sampling moment and the equivalent transition edge sampling moment is UI/2, a data sampling position in this case still falls in the middle of a UI. In this case, actual jitter tolerance is equal to theoretical jitter tolerance. Therefore, the phase detector 20 provided in this embodiment of this application does not cause degradation of jitter tolerance either.

That the data sampling comparator 22 performs sampling on the output of the data integrator 21 is equivalent to that the data sampling comparator 22 performs sampling on the input data at the equivalent data sampling position in FIG. 5A.

The data sampling comparator 22 compares sampled data with a specified value. For example, the specified value is 0. In this case, when the sampled data is greater than 0, the data sampling comparator 22 outputs a data signal 1; or when the sampled data is less than 0, the data sampling comparator 22 outputs a digital signal 0.

Similarly, that the transition edge sampling comparator 24 performs sampling on the output of the transition edge integrator 23 is equivalent to that the transition edge sampling comparator 24 performs sampling on the input data at the equivalent transition edge sampling position in FIG. 5A.

The transition edge sampling comparator 24 compares sampled data with the specified value. For example, when the sampled data is greater than 0, the transition edge sampling comparator 24 outputs a data signal 1; or when the sampled data is less than 0, the transition edge sampling comparator 24 outputs a digital signal 0.

Therefore, a signal output by the data sampling comparator 22 to the logic processor 25 is the digital signal 0 or the digital signal 1, and a signal output by the transition edge sampling comparator 24 to the logic processor 25 is also the digital signal 0 or the digital signal 1.

The logic processor 25 is configured to perform logic processing on a comparison result of the data sampling comparator 22 and a comparison result of the transition edge sampling comparator 24, and output a processing result.

In some embodiments, the logic processor 25 has a first output end and a second output end.

When a sampling comparison result (for example, 1) output by the data sampling comparator 22 at the $N^{th}$ rising edge of the sampling clock is different from a sampling result (for example, 0) output by the transition edge sampling comparator 24 at the $N^{th}$ rising edge of the delayed sampling clock, the sampling result (for example, 1) output by the transition edge sampling comparator 24 at the $N^{th}$ rising edge of the delayed sampling clock is the same as a sampling comparison result (for example, 1) output by the data sampling comparator 22 at the $(N+1)^{th}$ rising edge of the sampling clock, and this determining result is always obtained through logic determining, the logic processor 25 outputs a digital signal (for example, a digital signal 1) through the first output end, to indicate that a phase of the sampling clock leads a phase of the input data. In addition, in this case, the first output end of the logic processor 25 continuously outputs 1, and the second output end of the logic processor 25 continuously outputs 0.

When a sampling result (for example, 0) output by the transition edge sampling comparator 24 at the $N^{th}$ rising edge of the delayed sampling clock is different from a sampling comparison result (for example, 1) output by the data sampling comparator 22 at the $(N+1)^{th}$ rising edge of the sampling clock, a sampling comparison result (for example, 0) output by the data sampling comparator 22 at the $N^{th}$ rising edge of the sampling clock is the same as the sampling result (for example, 0) output by the transition edge sampling comparator 24 at the $N^{th}$ rising edge of the delayed sampling clock, and this determining result is always obtained through logic determining, the logic processor 25 outputs a digital signal (for example, a digital signal 1) through the second output end, to indicate that a phase of the sampling clock lags behind a phase of the input data. In addition, in this case, the first output end of the logic processor 25 continuously outputs 0, and the second output end of the logic processor 25 continuously outputs 1.

When a sampling comparison result (for example, 1) output by the data sampling comparator 22 at the $N^{th}$ rising edge of the sampling clock is different from a sampling result (for example, 0) output by the transition edge sampling comparator 24 at the $N^{th}$ rising edge of the delayed sampling clock, and the sampling result (for example, 0) output by the transition edge sampling comparator 24 at the $N^{th}$ rising edge of the delayed sampling clock is the same as a sampling comparison result (for example, 0) output by the data sampling comparator 22 at the $(N+1)^{th}$ rising edge of the sampling clock, this indicates that a comparison result is leading. Then a sampling result (for example, 1) output by the transition edge sampling comparator 24 at an $(N+1)^{th}$ rising edge of the delayed sampling clock is different from a sampling comparison result (for example, 0) output by the data sampling comparator 22 at an $(N+2)^{th}$ rising edge of the sampling clock, and a sampling comparison result (for example, 1) output by the data sampling comparator 22 at the $(N+1)^{th}$ rising edge of the sampling clock is the same as the sampling result (for example, 1) output by the transition edge sampling comparator 24 at the $(N+1)^{th}$ rising edge of the delayed sampling clock. This indicates that a comparison result is lagging. The comparison result oscillating between leading and lagging indicates that jitter of the phase of the sampling clock relative to the phase of the input data falls within a tolerance range. In addition, in this case, output of the logic processor 25 is as follows: The first output end outputs 1, and the second output end outputs 0; and the first output end outputs 0, and the second output end outputs 1. Output is performed in this alternate and oscillating manner.

Certainly, "0" and "1" in the foregoing digital signals are interchangeable. This still falls within the protection scope of embodiments of this application.

In this case, that the first output end continuously outputs the digital signal 1 and the second output end continuously outputs the digital signal 0 indicates that the logic processor 25 outputs a first signal, to indicate that the phase of the sampling clock leads the phase of the input data.

That the first output end continuously outputs the digital signal 0 and the second output end continuously outputs the digital signal 1 indicates that the logic processor 25 outputs a second signal, to indicate that the phase of the sampling clock lags behind the phase of the input data.

The output in the alternate and oscillating manner in which the first output end outputs 1 and the second output end outputs 0, and the first output end outputs 0 and the second output end outputs 1 indicates that the logic processor 25 outputs a third signal, to indicate that jitter of the phase of the sampling clock relative to the phase of the input data falls within the tolerance range.

Certainly, as shown in FIG. 5C, the data integrator 21 may alternatively perform integration on the input data at the data input end TD by starting from an $(N-1)^{th}$ rising edge of the delayed sampling clock and ending at the $N^{th}$ rising edge of the sampling clock, and

the transition edge integrator 23 performs integration on the input data at the data input end TD by starting from the $N^{th}$ rising edge of the sampling clock and ending at the $N^{th}$ rising edge of the sampling clock.

A principle thereof is the same as the principle of the integration manner shown in FIG. 5A. Refer to the foregoing related descriptions. Details are not described herein again.

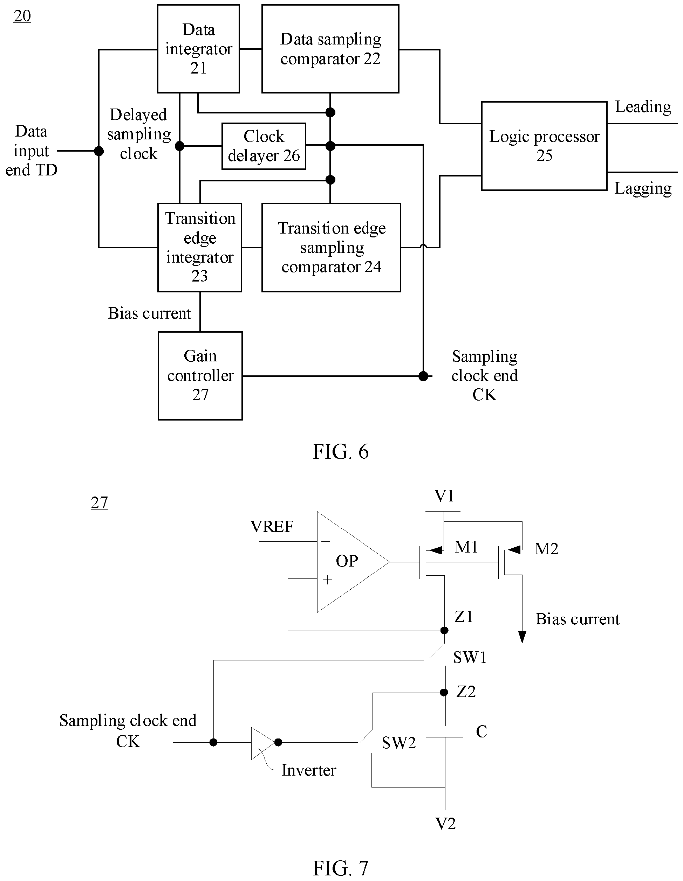

In some embodiments, as shown in FIG. 6, the phase detector 20 further includes a gain controller 27. The gain controller 27 is coupled to the transition edge integrator 23 and is configured to output a bias current to the transition edge integrator 23.

It can be learned from the foregoing descriptions that a gain $G_{21}$ of the data integrator 21 is as follows:

$$G_{21} = \frac{I}{C_O} * \frac{tdel}{V} = I * \frac{1}{C_O * V * FREQ}$$

In some embodiments, a structure of the data integrator 21 is the same as a structure of the transition edge integrator 23.

In this case, the structure of the data integrator 21 is equal to $C_O$ and V of the transition edge integrator 23. However, delay time tdel of the data integrator 21 is delay time of the clock delayer 26, and is controlled by a structure of the clock delayer 26. After the structure of the clock delayer 26 is fixed, the delay time tdel of the data integrator 21 is a fixed value. Delay time tdel of the transition edge integrator 23 is one UI, and the UI is limited by the input data at the data input end TD. Even if a structure of the phase detector 20 is fixed, the delay time tdel of the transition edge integrator 23 is a variable based on different input data. Consequently, the gain $G_{21}$ of the data integrator 21 is unequal to a gain $G_{23}$ of the transition edge integrator 23.

The gain controller 27 is disposed, so that the gain controller 27 generates a bias current $I_1$ that is directly proportional to a sampling clock frequency *FREQ* (namely, 1/UI) and provides the bias current $I_1$ for the transition edge integrator 23. For example, the bias current output by the gain controller 27 is as follows: $I_1 = K * FREQ$.

In this case, the gain $G_{23}$ of the transition edge integrator 23 is as follows:

$$G_{23} = K * FREQ * \frac{1}{C_O*V*FREQ} = \frac{K}{C_O*V},$$

where

K is a ratio of the bias current $I_1$ to the sampling clock frequency FREQ.

A design parameter of the gain controller 27 may be adjusted to meet the following condition: $K = I * tdel$. In this case, the gain $G_{23}$ of the transition edge integrator 23 is as follows:

$$G_{23} = \frac{K}{C_O * V} == \frac{I * tdel}{C_O * V} = I * \frac{1}{C_O * V * FREQ} = G_{21}$$

Therefore, with the gain controller 27 disposed in the phase detector 20, the gain controller 27 may compensate for the gain of the transition edge integrator 23, so that the gain $G_{21}$ of the data integrator 21 is equal to the gain $G_{23}$ of the transition edge integrator 23 to a maximum extent. In this way, the delay and the non-ideality introduced by the data integrator 21 can offset the delay and the non-ideality introduced by the transition edge integrator 23 to a maximum extent, to improve performance of the phase detector 20.

In some embodiments, as shown in FIG. 7, the gain controller 27 includes an operational amplifier OP, an inverter (inverter), a first transistor M1, a second transistor M2, a first switch SW1, a second switch SW2, and a capacitor.

An input end of the operational amplifier OP is coupled to a reference voltage end VREF, another input end of the operational amplifier OP is coupled to a first node Z1, and an output end of the operational amplifier OP is coupled to a gate of the first transistor M1.

A first electrode of the first transistor M1 is coupled to a first voltage end V1, and a second electrode of the first transistor M1 is coupled to the first node Z1.

A gate of the second transistor M2 is coupled to the output end of the operational amplifier OP, a first electrode of the second transistor M2 is coupled to the first voltage end V1, and a second electrode of the second transistor M2 is coupled to the transition edge integrator 23.

The first switch SW1 is coupled between the first node Z1 and a second node Z2, and a control end of the first switch SW1 is coupled to the sampling clock end CK.

An input end of the inverter is coupled to the sampling clock end CK, an output end of the inverter is coupled to a control end of the second switch SW2, and the second switch SW2 and the capacitor C are coupled in parallel between the second node Z2 and a second voltage end V2.

For example, the first voltage end V1 may be a power voltage end, and the second voltage end V2 may be a reference ground voltage end.

Certainly, a structure of the gain controller 27 in embodiments of this application is not limited to the structure shown in FIG. 7. Any structure that can implement a function of the gain controller 27 or a structure that has a same implementation principle as the structure shown in FIG. 7 falls within the protection scope of embodiments of this application.

For example, the gain controller 27 may include a transistor connected in series or in parallel to the first transistor M1, the gain controller 27 may include a transistor connected in series or in parallel to the second transistor M2, the gain controller 27 may include a switch connected in series or in parallel to the first switch SW1, or the gain controller 27 may include a switch connected in series or in parallel to the second switch SW2.

During operation of the gain controller 27, a reverse sampling clock is generated, through the inverter, for a sampling clock input to the sampling clock end CK. When the sampling clock is 1, the first switch SW1 is turned on, and the second switch SW2 is turned off. The first transistor M1 transmits a signal at the first voltage end V1 to the capacitor C, to charge the capacitor C. When the sampling clock is 0, the first switch SW1 is turned off, the second switch SW2 is turned on, and the capacitor C discharges to the second voltage end V2. In this case, from a perspective from the first node Z1 to the capacitor C, a resistor R may be equivalently obtained:

$$R = \frac{1}{FREQ * C}$$

The operational amplifier OP maintains the first node Z1 at a voltage at the reference voltage end VREF through negative feedback. Therefore, the bias current $I_1$ flowing through the first transistor M1 is as follows:

$$I_1 = \frac{VREF}{R} = VREF * FREQ * C$$

Therefore, the following is obtained:

$$K = \frac{I_1}{FREQ} = VREF * C$$

A design parameter of the capacitor C may be adjusted to meet the following condition: K = I * tdel. In this case, the gain $G_{23}$ of the transition edge integrator 23 is the same as the gain $G_{21}$ of the data integrator 21.

With the gain controller 27 disposed, the gain $G_{23}$ of the transition edge integrator 23 may be adjusted to make the gain $G_{23}$ of the transition edge integrator 23 be the same as the gain $G_{21}$ of the data integrator 21, so that the delay and the non-ideality introduced by the data integrator 21 are symmetric to and offset the delay and the non-ideality introduced by the transition edge integrator 23, to alleviate jitter tolerance degradation caused by the introduction of the integrators, improve jitter tolerance of the phase detector 20, and further improve performance of the phase detector 20.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

**Claims**

1. A phase detector, comprising:

   a data integrator, coupled to a sampling clock end and configured to perform integration on input data based on a signal at the sampling clock end;
   a data sampling comparator, configured to perform sampling comparison between output of the data integrator and a specified value;
   a transition edge integrator, coupled to the sampling clock end and configured to perform integration on the input data based on the signal at the sampling clock end;
   a transition edge sampling comparator, configured to perform sampling comparison between output of the transition edge integrator and the specified value; and
   a logic processor, configured to perform logic processing on a comparison result of the data sampling comparator and a comparison result of the transition edge sampling comparator, and output a processing result.

2. The phase detector according to claim 1, wherein the phase detector further comprises a clock delayer; and
   the sampling clock end, the data integrator, and the transition edge integrator are all coupled to the clock delayer, and the clock delayer is configured to receive a sampling clock from the sampling clock end and output a delayed sampling clock.

3. The phase detector according to claim 2, wherein
   the data integrator is configured to perform integration on the input data by starting from an $N^{th}$ rising edge of the sampling clock and ending at an $N^{th}$ rising edge of the delayed sampling clock, and the transition edge integrator is configured to perform integration on the input data by starting from the $N^{th}$ rising edge of the delayed sampling clock and ending at an $(N+1)^{th}$ rising edge of the sampling clock, wherein N is a positive integer.

4. The phase detector according to claim 3, wherein
   the data integrator is configured to perform integration on the input data by starting from an $(N-1)^{th}$ rising edge of the delayed sampling clock and ending at the $N^{th}$ rising edge of the sampling clock, and the transition edge integrator is configured to perform integration on the input data by starting from the $N^{th}$ rising edge of the sampling clock and ending at the $N^{th}$ rising edge of the sampling clock, wherein N is a positive integer.

5. The phase detector according to any one of claims 1 to 4, wherein the data integrator and the transition edge integrator have a same structure.

6. The phase detector according to any one of claims 1 to 5, wherein the phase detector further comprises a gain controller, and the gain controller is coupled to the transition edge integrator and is configured to output a bias current to the transition edge integrator.

7. The phase detector according to claim 6, wherein the gain controller comprises an operational amplifier, an inverter, a first transistor, a second transistor, a first switch, a second switch, and a capacitor;

   an input end of the operational amplifier is coupled to a reference voltage end, another input end of the operational amplifier is coupled to a first node, and an output end of the operational amplifier is coupled to a gate of the first transistor;
   a first electrode of the first transistor is coupled to a first voltage end, and a second electrode of the first transistor is coupled to the first node;
   a gate of the second transistor is coupled to the output end of the operational amplifier, a first electrode of the second transistor is coupled to the first voltage end, and a second electrode of the second transistor is coupled to the transition edge integrator;
   the first switch is coupled between the first node and a second node, and a control end of the first switch is coupled to the sampling clock end; and
   an input end of the inverter is coupled to the sampling clock end, an output end of the inverter is coupled to a control end of the second switch, and the second switch and the capacitor are coupled in parallel between the second node and a second voltage end.

8. The phase detector according to any one of claims 3 to 7, wherein the clock delayer comprises a buffer.

9. The phase detector according to any one of claims 1 to 8, wherein the logic processor has a first output end and a second output end; and

the logic processor is configured to output a digital signal from the first output end, to represent that a phase of the sampling clock leads a phase of the input data; or
the logic processor is configured to output the digital signal from the second output end, to represent that a phase of the sampling clock lags behind a phase of the input data.

10. The phase detector according to any one of claims 1 to 8, wherein the specified value is 0.

11. A clock and data recovery circuit, comprising a phase detector and a charge pump, wherein the phase detector is the phase detector according to any one of claims 1 to 10, and the phase detector is coupled to the charge pump.

12. An electronic device, comprising a drive chip and a clock and data recovery circuit, wherein the clock and data recovery circuit is disposed in the drive chip, and the clock and data recovery circuit is the clock and data recovery circuit according to claim 11.

13. An operation method for a phase detector, comprising:

performing, by a data integrator, integration on input data;
performing, by a data sampling comparator, sampling comparison between output of the data integrator and a specified value;
performing, by a transition edge integrator, integration on the input data;
performing, by a transition edge sampling comparator, sampling comparison between output of the transition edge integrator and the specified value; and
performing, by a logic processor, logic processing on a comparison result of the data sampling comparator and a comparison result of the transition edge sampling comparator, and outputting a processing result.

FIG. 1A

FIG. 1B

Source drive circuit

FIG. 1C

CDR

```
                                                          ┌──────────────┐
                                                          │ Data recovery│─────▶ DT
                                                          │   circuit    │
                                                          └──────────────┘
        ┌ ─ ─ ─ ─ ─ ─ ─ ─ ─ ─ ─ ─ ─ ─ ─ ─ ─ ─ ─ ─ ─ ─ ─ ─ ─ ─ ─ ─ ┐
        │  ┌─────────┐   ┌──────────┐   ┌───────────┐   ┌──────┐  │
TD ────▶│  │  Phase  │─▶ │  Charge  │─▶ │Loop filter│─▶ │ VCO  │  │───▶ CK
        │  │ detector│   │   pump   │   │           │   │      │  │
        │  └─────────┘   └──────────┘   └───────────┘   └──────┘  │
        └ ─ ─ ─ ─ ─ ─ ─ ─ ─ ─ ─ ─ ─ ─ ─ ─ ─ ─ ─ ─ ─ ─ ─ ─ ─ ─ ─ ─ ┘
             20
```

FIG. 1D

20

```
              ┌──────────────────┐
              │  Data sampling   │
              │    comparator    │
              └──────────────────┘
                                        Sampling        ┌───────────┐
Input data                              clock 1         │   Logic   │──── Leading
                                                        │ processor │
                                        Sampling        │           │──── Lagging
                                        clock 2         └───────────┘
              ┌──────────────────┐
              │ Transition edge  │
              │    sampling      │
              │    comparator    │
              └──────────────────┘
```

FIG. 2A

Input data

Ideal

Sampling          Sampling          Sampling
clock 2<N–1>      clock 1<N>        clock 2<N>

Lagging

FIG. 2B

Input data

Leading

Ideal

Sampling
clock 2<N−1>

Sampling
clock 1<N>

Sampling
clock 2<N>

FIG. 2C

20

Input data

Integrator

Data sampling
comparator

Transition edge
sampling
comparator

Sampling
clock

Logic
processor

Leading

Lagging

FIG. 3A

$\Delta t$

Input data

v

CKPRE          CKPOST

tdel

Integrator
output

$\Delta t$

$V_O$

CKPRE          CKPOST

tdel

## FIG. 3B

Integrator delay
and non-ideality

Input data

Theoretical
jitter tolerance

Actual jitter
tolerance

Sampling clock <N>                    Sampling clock <N+1>

Theoretical equivalent     Actual equivalent
sampling position          sampling position

## FIG. 3C

Delay and non-ideality of a
transition edge integrator

Theoretical
jitter tolerance

Actual jitter
tolerance

Theoretical
transition edge
sampling position

Actual transition
edge sampling
position

Actual data
sampling position

FIG. 3D

20

| Data integrator 21 | Data sampling comparator 22 |

Data input end TD

Sampling clock end CK

| Logic processor 25 |

Leading

Lagging

| Transition edge integrator 23 | Transition edge sampling comparator 24 |

FIG. 4A

20

Data
integrator
21

Data sampling
comparator 22

Data
input
end TD

Delayed
sampling
clock

Clock
delayer 26

Sampling
clock end
CK

Logic processor
25

Leading

Lagging

Transition
edge
integrator
23

Transition edge
sampling
comparator 24

FIG. 4B

tdel

UI

Sampling
clock N

Delayed sampling
clock N

Sampling
clock N+1

Equivalent data
sampling position
obtained through
integration

Equivalent transition
edge sampling
position obtained
through integration

FIG. 5A

Delay and non-ideality of a transition edge integrator

Delay and non-ideality of a data integrator

Theoretical jitter tolerance

Actual jitter tolerance

Theoretical transition edge sampling position

Actual transition edge sampling position

Theoretical data sampling position

Actual data sampling position

FIG. 5B

tdel

UI

Delayed sampling clock N–1

Sampling clock N

Delayed sampling clock N

Equivalent data sampling position obtained through integration

Equivalent transition edge sampling position obtained through integration

FIG. 5C

20

```
┌──────────┐  ┌──────────────┐
│   Data   │  │ Data sampling│
│integrator│  │ comparator 22│
│    21    │  │              │
└──────────┘  └──────────────┘
```

Data
input
end TD

Delayed
sampling
clock

┌──────────────┐
│    Clock     │
│  delayer 26  │
└──────────────┘

Leading

┌──────────────┐
│Logic processor│
│      25       │
└──────────────┘

Lagging

┌──────────┐  ┌──────────────┐
│Transition│  │ Transition edge│
│   edge   │  │   sampling     │
│integrator│  │ comparator 24  │
│    23    │  │                │
└──────────┘  └──────────────┘

Bias current

┌──────────┐
│   Gain   │
│controller│
│    27    │
└──────────┘

Sampling
clock end
CK

FIG. 6

27

VREF

OP

V1

M1    M2

Bias current

Z1

SW1

Z2

Sampling clock end
CK

Inverter

SW2

C

V2

FIG. 7

EP 4 593 291 A1

## INTERNATIONAL SEARCH REPORT

| | International application No. |
|---|---|
| | **PCT/CN2023/103186** |

### A. CLASSIFICATION OF SUBJECT MATTER

H03L7/085(2006.01)i

According to International Patent Classification (IPC) or to both national classification and IPC

### B. FIELDS SEARCHED

Minimum documentation searched (classification system followed by classification symbols)

IPC: H03L

Documentation searched other than minimum documentation to the extent that such documents are included in the fields searched

Electronic data base consulted during the international search (name of data base and, where practicable, search terms used)

CNTXT, CNABS, WOTXT, EPTXT, JPTXT, USTXT, VEN, CNKI, IEEE: 鉴相, 相位鉴别, 相位识别, 相位检测, 时钟, 数据恢复, 积分, 采样, 比较, 跳变沿, 边沿, phase detector, Clock, data recovery, integrate, sample, comparator, edge

### C. DOCUMENTS CONSIDERED TO BE RELEVANT

| Category* | Citation of document, with indication, where appropriate, of the relevant passages | Relevant to claim No. |
|---|---|---|
| A | CN 107257241 A (CHIPONE TECHNOLOGY (BEIJING) CO., LTD.) 17 October 2017 (2017-10-17) description, paragraphs 0032-0062, and figures 1-6 | 1-13 |
| A | CN 104539285 A (FUDAN UNIVERSITY) 22 April 2015 (2015-04-22) entire document | 1-13 |
| A | CN 102281060 A (CHANGSHA JINGJIA MICROELECTRONICS CO., LTD.) 14 December 2011 (2011-12-14) entire document | 1-13 |
| A | CN 113992319 A (NATIONAL UNIVERSITY OF DEFENSE TECHNOLOGY OF PLA) 28 January 2022 (2022-01-28) entire document | 1-13 |
| A | US 8669786 B1 (INTERNATIONAL BUSINESS MACHINES CORP.) 11 March 2014 (2014-03-11) entire document | 1-13 |
| A | JP 2011234009 A (RENESAS ELECTRONICS CORP.) 17 November 2011 (2011-11-17) entire document | 1-13 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **18 September 2023** | **22 September 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/103186**

| Patent document cited in search report | | | Publication date (day/month/year) | Patent family member(s) | | | Publication date (day/month/year) |
|---|---|---|---|---|---|---|---|
| CN | 107257241 | A | 17 October 2017 | None | | | |
| CN | 104539285 | A | 22 April 2015 | US | 2015180644 | A1 | 25 June 2015 |
| | | | | US | 9219599 | B2 | 22 December 2015 |
| CN | 102281060 | A | 14 December 2011 | None | | | |
| CN | 113992319 | A | 28 January 2022 | None | | | |
| US | 8669786 | B1 | 11 March 2014 | US | 2014159775 | A1 | 12 June 2014 |
| | | | | US | 9077319 | B2 | 07 July 2015 |
| JP | 2011234009 | A | 17 November 2011 | JP | 5520128 | B2 | 11 June 2014 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211314210